# EUROPÄISCHE PATENTSCHRIFT

(11) **EP 2 006 910 B1**
(45) Veröffentlichungstag und Bekanntmachung des Hinweises auf die Patenterteilung: **16.03.2016**
(21) Anmeldenummer: 08104205.3
(22) Anmeldetag: 02.06.2008
(51) Int. Cl.: H01L 23/373, H01L 23/538, H01L 25/07, H01L 25/065

(54) **Leistungselektronikmodul**
Power electronics module
Module électronique de puissance

(30) Priorität: 18.06.2007 DE 102007027901
(43) Veröffentlichungstag der Anmeldung: 24.12.2008
(73) Patentinhaber: ROBERT BOSCH GMBH, 70442 Stuttgart (DE)
(72) Erfinder: Donis, Dieter, 70439, Stuttgart (DE); Ruf, Christoph, 72800, Eningen (DE)

(56) Entgegenhaltungen:
- US-A1- 2006 120 056

## Beschreibung

Die Erfindung betrifft ein Leistungselektronikmodul mit mindestens einem Schaltungsträger und mindestens einem Leistungshalbleiter.

### Stand der Technik

Leistungselektronikmodule der eingangs genannten Art sind aus dem Stand der Technik bekannt. Diese weisen einen Schaltungsträger auf, an dem der Leistungshalbleiter angeordnet ist. Schaltungsträger und Leistungshalbleiter sind dabei fest miteinander verbunden, wobei in der Regel ein Schaltungsträger auf Keramikbasis (DCB/DBC = Direct Bonded Copper) oder Metallbasis (IMS = Integrated Metal Substrate/Metallplatte mit Isolation und Schaltung oder Stanzgitterlösungen) verwendet wird. Hierdurch wird sichergestellt, dass hohe Ströme transportiert und gleichzeitig entstehende beziehungsweise entstandene Wärme von dem Leistungshalbleiter oder den Leistungshalbleitern abgeführt werden kann. Thermisch günstige Schaltungsträger sind jedoch in ihrer Herstellung teuer und zur elektrischen Kontaktierung der Leistungshalbleiter sind eine Vielzahl von Lötprozessen und/oder Drahtbondprozessen notwendig.

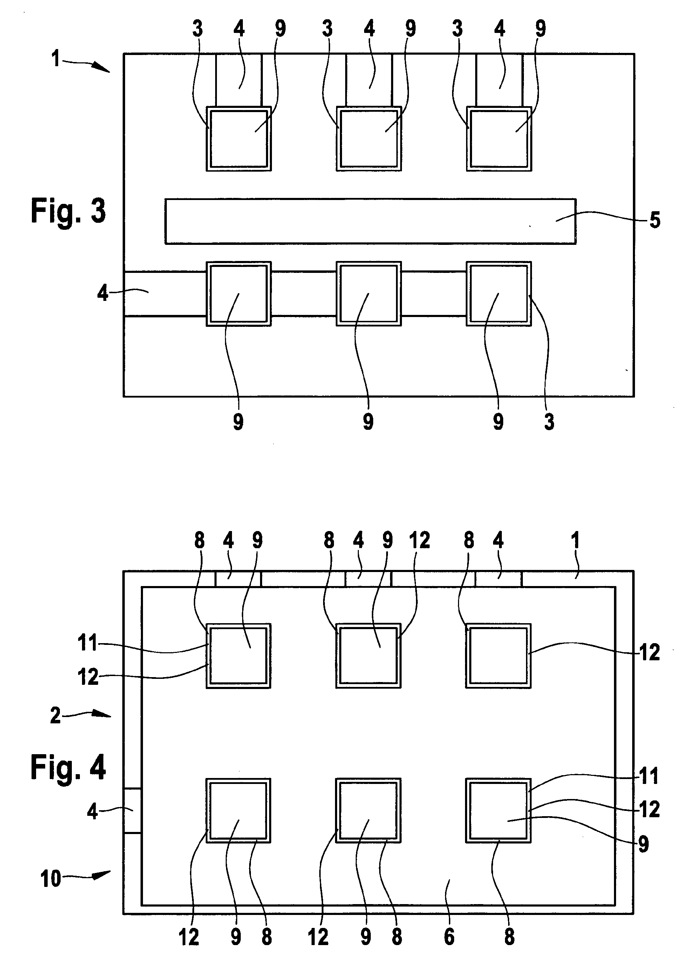

US 2006/0120056 A1 offenbart ein Leistungselektronikmodul, welches in einem Zwischenherstellschritt (siehe Fig. 4B) eine Anordnung von außenseitig angeordneten Basisplatten und einer zwischen den Basisplatte angeordneten Entwärmungsplatte aufweist Zwischenräume zwischen den Basisplatten sind mit einem Kunststoff ausgefüllt Ferner ist die Entwärmungsplatte durch eine Schicht dieses Kunststoffes jeweils zu einer Basisplatte beabstandet angeordnet. Die Entwärmungsplatte ist als metallische Platte vorgesehen, z.B. aus Aluminium.

### Offenbarung der Erfindung

Die Erfindung sieht vor, dass der Schaltungsträger ein flexibles Kunststoffträgersubstrat, insbesondere mit Kupfer-Leiterbahnen, aufweist, auf dem der Leistungshalbleiter montiert ist, dass der Schaltungsträger ein flexibles Entwärmungssubstrat aufweist, das flächig auf dem Kunststoffträgersubstrat angeordnet ist und dass der Schaltungsträger ein flexibles Kontaktierungssubstrat aufweist, das flächig auf dem sich aus Kunststoffträgersubstrat und Entwärmungssubstrat zusammensetzenden Bauteil angeordnet ist. Es ist also ein Schaltungsträger mit einem schichtartigen Aufbau vorgesehen, wobei die Basis von dem Kunststoffträgersubstrat gebildet ist, welches vorteilhafterweise flexibel gestaltet ist. Auf diesem ist der Leistungshalbleiter montiert. Im Gegensatz zu einem aus dem Stand der Technik bekannten Schaltungsträger ist der vorliegende Schaltungsträger aufgrund der Verwendung des Kunststoffträgersubstrats günstiger und einfacher herstellbar. Das Entwärmungssubstrat dient zum Abführen beziehungsweise Spreizen und Verteilen der Wärme von dem Leistungshalbleiter beziehungsweise dem Schaltungsträger. Letztendlich wird die Wärme über Kupfer auf dem Kunststoffträgersubstrat und dem Kontaktierungssubstrat abgeführt. Es ist ebenfalls flexibel ausgebildet und ist flächig auf dem Kunststoffträgersubstrat angeordnet, sodass das Entwärmungssubstrat das Kunststoffträgersubstrat vorteilhafterweise im Wesentlichen abdeckt, wobei besonders bevorzugt das Entwärmungssubstrat etwas kleiner ausgebildet ist, sodass ein Randbereich des Kunststoffträgersubstrat frei zugängig ist. Hierdurch wird ein einfaches Kontaktieren von auf dem Kunststoffträgersubstrat angeordneten elektrischen Kontakten, die von oder zu dem Leistungshalbleiter führen, gewährleistet. Das Kunststoffträgersubstrat und das Entwärmungssubstrat bilden zusammen ein Bauteil, auf dem das Kontaktierungssubstrat flächig angeordnet ist. Da sowohl das Kunststoffträgersubstrat, das Entwärmungssubstrat als auch das Kontaktierungssubstrat flexibel ausgebildet sind, wird ein flexibles Leistungselektronikmodul zur Verfügung gestellt. Wobei die Flexibilität des Leistungselektronikmoduls natürlich auch von weiteren Faktoren, wie der Größe und Anzahl von auf dem Schaltungsträger angeordneten Leiterbahnen und/oder den Dimensionen sowie der Anzahl der Leistungshalbleiter abhängig ist. Durch die flexible Ausgestaltung wird zum Einen die Zuverlässigkeit des Leistungselektronikmoduls auf lange Sicht hin erhöht, da es sich an verändernde Umgebungsbedingungen sowie Form- und/oder Lagetoleranzen anpassen kann, und zum Anderen wird durch das Entwärmungssubstrat eine besonders günstige Entwärmung des Leistungselektronikmoduls gewährleistet.

Nach einer Weiterbildung der Erfindung weist das Entwärmungssubstrat mindestens eine Ausnehmung zur Aufnahme des Leistungshalbleiters auf. Der Leistungshalbleiter ragt somit in das Entwärmungssubstrat hinein oder durch dieses hindurch, wodurch zum Einen die Wärmeabfuhr von von dem Leistungshalbleiter entwickelter Wärme erhöht und erleichtert wird und zum Anderen der Leistungshalbleiter von dem Kontaktiersubstrat kontaktiert werden kann. Vorteilhafterweise sind an dem Kunststoffträgersubstrat und an dem Kontaktierungssubstrat auf den zueinander weisenden Seiten Kontaktelemente und/oder Leiterbahnen angeordnet, über die der Leistungshalbleiter elektrisch kontaktiert werden kann.

Nach einer Weiterbildung der Erfindung weist das Kunststoffträgersubstrat mindestens eine mit dem Leistungshalbleiter verbundene Hochstromverbindung auf. Die Hochstromverbindung führt vorteilhafterweise bis zu dem Randbereich des Kunststoffträgersubstrats, der frei zugängig ist, sodass die Hochstromverbindung von außen auf einfache Art und Weise elektrisch kontaktiert werden kann. Vorteilhafterweise ist das Kunststoffträgersubstrat ein Polyimidsubstrat, insbesondere mit Kupfer-Leiterbahnen.

Weiterhin ist vorgesehen, dass das Kontaktiersubstrat mindestens eine Niederstrom- und/oder eine Hochstromverbindung für den Leistungshalbleiter aufweist. Zweckmäßigerweise ist die Hochstromverbindung des Kunststoffträgersubstrats mit dem Drain-Anschluss des Leistungshalbleiters verbunden. Weiterhin sind die Niederstrom- und/oder Hochstromverbindungen des Kontaktierungssubstrats mit Gate- und/oder Source-Anschlüssen des Leistungshalbleiters verbunden.

Mit Vorteil ist vorgesehen, dass das Entwärmungssubstrat eine Graphit-Folie ist. Diese kann auf einfache Art und Weise, zum Beispiel durch Stanzen, Lasern oder Ähnlichem, "zugeschnitten" und auf dem Kunststoffträgersubstrat angeordnet werden. Derartige Graphit-Folien sind kostengünstig herstellbar.

Bevorzugt ist zwischen dem Entwärmungssubstrat und dem Leistungshalbleiter ein Wärmeleitmittel (Gap-Filler) angeordnet. Dadurch wird der Leistungshalbleiter thermisch an das Entwärmungssubstrat beziehungsweise die Graphitfolie angebunden, sodass eine besonders günstige Entwärmung des Leistungshalbleiters erfolgt. Das vorteilhafterweise viskose Wärmeleitmittel dient somit als thermisches Kontaktmittel zwischen Leistungshalbleiter und Entwärmungssubstrat.

In einer bevorzugten Ausführungsform der Erfindung weist das Kunststoffträgersubstrat und/oder das Entwärmungssubstrat mindestens ein Entwärmungsflächenelement auf, das mit dem Entwärmungssubstrat in thermischen Kontakt steht. Über das Entwärmungsflächenelement kann beispielsweise auch Wärme von dem Kunststoffträgersubstrat auf das Entwärmungssubstrat übertragen werden. In einer alternativen Ausführungsform ist das Entwärmungsflächenelement auf dem Kunststoffträgersubstrat angeordnet und steht nicht in thermischem Kontakt mit dem Entwärmungssubstrat, sodass es lediglich als Entwärmungspad für das Kunststoffträgersubstrat dient.

In einer vorteilhaften Weiterbildung der Erfindung sind die Leistungshalbleiter durch Verklebung und/oder Lötung auf dem Kunststoffträgersubstrat montiert.

Zusätzlich ist vorgesehen, dass der Leistungshalbleiter zwischen dem Kunststoffträgersubstrat und dem Entwärmungssubstrat (im montierten Zustand) klemmend gehalten ist. Hierbei wird der Leistungshalbleiter zum Beispiel durch das Kontaktierungssubstrat auf das Kunststoffträgersubstrat gedrückt und somit in einer festen Position gehalten. Dies ermöglicht eine besonders einfache und schnelle Montage des Leistungselektronikmoduls.

### Kurze Beschreibung der Zeichnungen

Im Folgenden soll die Erfindung anhand einiger Figuren näher erläutert werden. Dazu zeigen
- Figur 1: ein Ausführungsbeispiel eines vorteilhaften Kunststoffträgersubstrats eines Leistungselektronikmoduls in einer Draufsicht,
- Figur 2: ein vorteilhaftes Entwärmungssubstrat des Leistungselektronikmoduls in einer Draufsicht,
- Figur 3: das Kunststoffträgersubstrat des Leistungselektronikmoduls in einer weiteren Draufsicht mit Leistungshalbleitern,
- Figur 4: das Kunststoffträgersubstrat und das Entwärmungssubstrat in einer Draufsicht,
- Figur 5: ein vorteilhaftes Kontaktierungssubstrat des Leistungselektronikmoduls in einer Draufsicht und
- Figur 6: einen Schaltungsträger des Leistungselektronikmoduls in einer Seitenansicht.

### Ausführungsform(en) der Erfindung

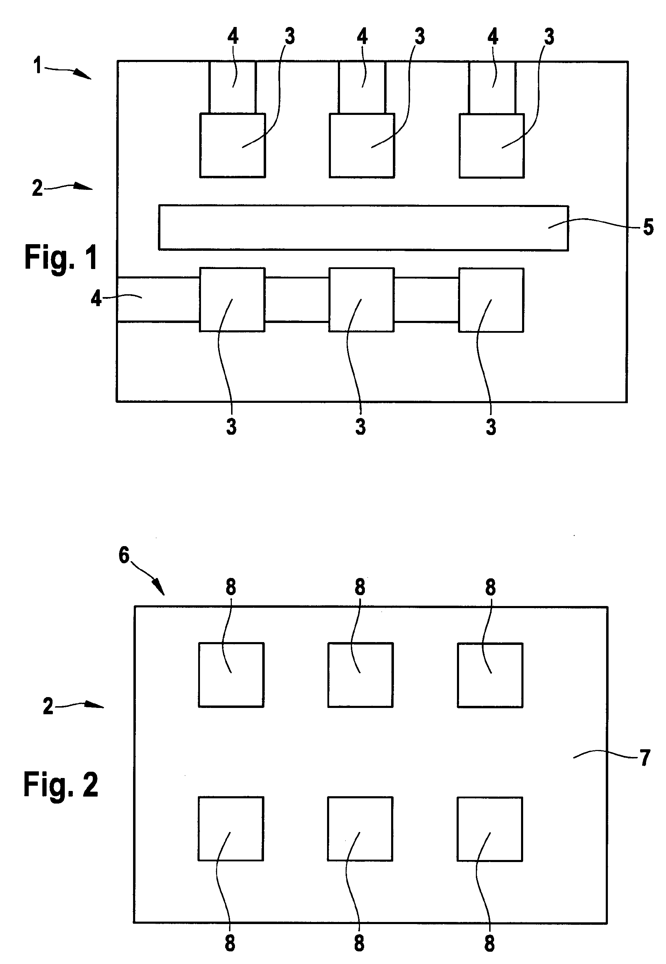

Die Figur 1 zeigt in einem Ausführungsbeispiel der Erfindung ein Kunststoffträgersubstrat 1 eines Leistungselektronikmoduls 2 in einer Draufsicht. Das Kunststoffträgersubstrat 1 ist im Wesentlichen rechteckförmig ausgebildet. Auf dem Kunststoffträgersubstrat 1 sind mehrere Leistungshalbleiteranschlüsse 3 angeordnet, die mit auf dem Kunststoffträgersubstrat 1 angeordneten Hochstromverbindungen 4 elektrisch verbunden sind. In dem vorliegenden Ausführungsbeispiel sind die Leistungshalbleiteranschlüsse 3 jeweils als Drain-Anschluss ausgebildet. Das Kunststoffträgersubstrat 1 ist vorteilhafterweise flexibel ausgebildet. Weiterhin ist auf dem Kunststoffträgersubstrat 1 ein Entwärmungselement 5 angeordnet, welches beispielsweise als Wärmespeicher dienen kann.

Die Figur 2 zeigt in einer Draufsicht ein Entwärmungssubstrat 6 des Leistungselektronikmoduls 2. Das Entwärmungssubstrat 6 ist von einer flexiblen Graphitfolie 7 gebildet. Seine Kontur entspricht im Wesentlichen der Kontur des in der Figur 1 dargestellten Kunststoffträgersubstrats 1. In dem Entwärmungssubstrat 6 sind mehrere Ausnehmungen 8 ausgebildet, deren Form und Anordnung im Wesentlichen der auf dem Kunststoffträgersubstrat 1 angeordneten Leistungshalbeiteranschlüsse 3 (Figur 1) entsprechen.

Die Figur 3 zeigt das Kunststoffträgersubstrat 1 der Figur 1 in einer weiteren Draufsicht. Im Unterschied zu der Figur 1 ist hierbei jeweils ein Leistungshalbleiter 9 auf einem der Leistungshalbleiteranschlüsse 3 montiert. Die Hochstromverbindungen 4 führen jeweils bis zu einer Außenkante des Kunststoffträgersubstrats 1.

Die Figur 4 zeigt das Kunststoffträgersubsubstrat 1 und das Entwärmungssubstrat 6, die zusammen ein Bauteil 10 des Leistungselektronikmoduls 2 bilden. Dabei ist das Entwärmungssubstrat 6 derart auf dem Kunststoffträgersubstrat 1 angeordnet, dass die auf dem Kunststoffträgersubstrat 1 angeordneten Leistungshalbleiter 9 in den Ausnehmungen 8 des Entwärmungssubstrats 6 einliegen beziehungsweise durch diese hindurchgreifen. Das Entwärmungssubstrat 6 ist etwas kleiner ausgebildet als das Kunststoffträgersubstrat 1, sodass ein Randbereich des Kunststoffträgersubstrats 1 frei zugängig ist, wodurch die bis an die Kanten des Kunststoffträgersubstrats 1 führenden Hochstromverbindungen 4 elektrisch kontaktiert werden können. Alternativ dazu können das Kunststoffträgersubstrat 1 und das Entwärmungssubstrat 6 eine gleich große Außenkontur aufweisen, wobei die Hochstromverbindungen 4 dann zweckmäßigerweise über die Außenkanten des Kunststoffträgersubstrats 1 hinausführen/ragen. Da die Ausnehmungen 8 des Entwärmungssubstrats 6 vorteilhafterweise größer ausgebildet sind als die Leistungshalbleiter 9, entsteht ein Spalt 11 zwischen den Leistungshalbleitern 9 und dem Rand der Ausnehmungen 8 des Entwärmungssubstrats 6. Vorteilhafterweise ist der Spalt 11 mit einem viskosen Wärmeleitmittel 12 (Gap-Filler) gefüllt, das eine thermische Anbindung der Leistungshalbleiter 9 an das Entwärmungssubstrat 6 gewährleistet, sodass die von den Leistungshalbleitern 9 entwickelte Wärme auf einfache Art und Weise abgeführt werden kann. Das in den Figuren 1 und 2 dargestellte Entwärmungselement 5 steht in dem vorliegenden Ausführungsbeispiel mit dem Entwärmungssubstrat 6 in Kontakt (hier nicht dargestellt), sodass auch hier eine thermische Verbindung besteht.

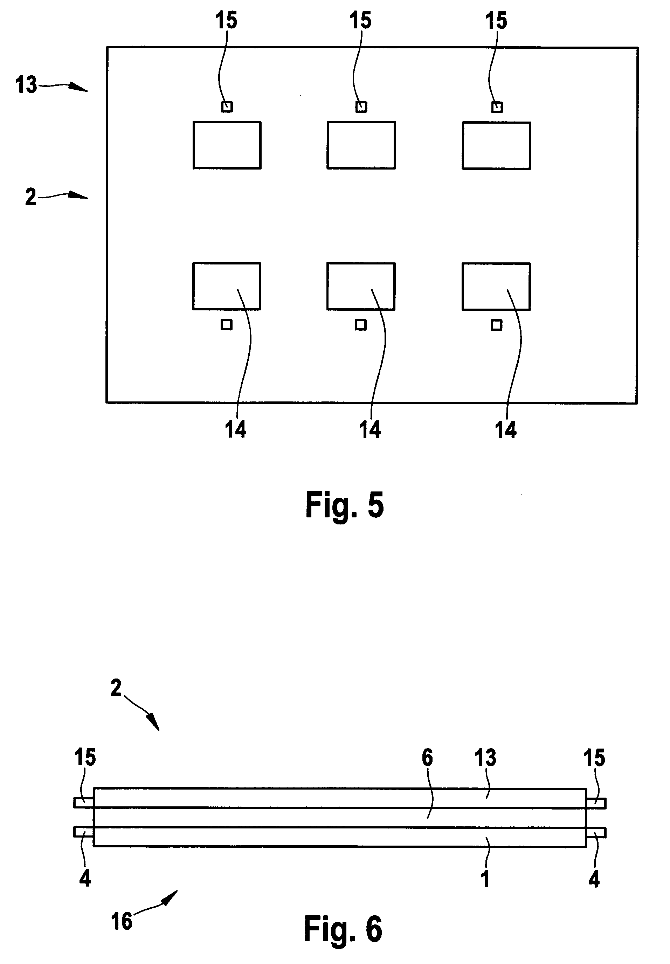

Die Figur 5 zeigt ein beispielhaftes Kontaktierungssubstrat 13 des Leistungselektronikmoduls 2. Das Kontaktierungssubstrat 13 ist ebenfalls flexibel ausgebildet und weist eine dem Kunststoffträgersubstrat 1 entsprechende Kontur auf. Auf dem Kontaktierungssubstrat 13 sind zum Einen Leistungshalbleiteranschlüsse 14 angeordnet, die als Source-Anschlüsse ausgebildet sind und zum Anderen Leistungshalbleiteranschlüsse 15, die als Gate-Anschlüsse ausgebildet sind. Sie sind derart angeordnet, dass wenn das Kontaktierungssubstrat 13 auf das Bauteil 10 gelegt wird, die auf dem Kunststoffträgersubstrat 2 angeordneten Leistungshalbleiter 9 kontaktiert werden.

Die Figur 6 zeigt dazu das vollständige Leistungselektronikmodul 2 in einer Seitenansicht. Hierbei liegt auf dem Bauteil 10, das von dem Kunststoffträgersubstrat 1 und dem Entwärmungssubstrat 6 gebildet wird, das aus der Figur 5 bekannte Kontaktierungssubstrat 13 auf. Durch die flexible Ausbildung des Kunststoffträgersubstrats 2, des Entwärmungssubstrats 6 sowie des Kontaktierungssubstrats 13 ist ein flexibles Leistungselektronikmodul 2 geschaffen. Die Leistungshalbleiter 9 können dabei zwischen dem Kunststoffträgersubstrat 1 und dem Kontaktierungssubstrat 13 eingeklemmt gehalten werden. Zusätzlich können die Leistungshalbleiter 9 auf dem Kunststoffträgersubstrat 2 beziehungsweise den Leistungshalbleiteranschlüssen 3 beispielsweise durch Verkleben oder Verlöten montiert sein.

Weiterhin zeigt die Figur 6 von dem Kunststoffträgersubstrat 1 abstehende Hochstromverbindungen 4, die oben bereits als alternative Ausbildungen der Hochstromverbindungen genannt wurden, und von dem Kontaktierungssubstrat 13 ausgehende Niederstromverbindungen 15.Vorteilhafterweise sind aus dem Kontaktierungssubstrat 13 sowohl Niederstromverbindungen 15 sowie Hochstromverbindungen angeordnet. Das Kunststoffträgersubstrat 1, das Entwärmungssubstrat 6, das Kontaktierungssubstrat 13 sowie die Leistungshalbleiter 9 und die elektrischen Verbindungen (4,14,15) bilden hierbei einen vorteilhaften Schaltungsträger 16 des Leistungselektronikmoduls 2.

Das vorliegende Leistungselektronikmodul 2 bietet zum Einen die bereits genannte Flexibilität, zum Anderen eine besonders günstige Wärmeabfuhr der von den Leistungshalbleitern 9 entwickelten Wärme. Das Leistungselektronikmodul 2 kann beispielsweise auf einer Leiterplatte durch Auflöten und/oder eine Heatsink oder durch Anlöten von Steckerpins kontaktiert und/oder befestigt werden.

Im Vergleich zu herkömmlichen Schaltungsträgern, insbesondere keramischen Schaltungsträgern, stellt das hier vorliegende Leistungselektronikmodul 2 eine kostengünstigere Lösung dar. Zum Einen werden die Kosten durch das Kunststoffträgersubstrat 1 und zum Anderen durch die Vermeidung von Löt- und/oder Drahtbondprozessen zur Anbindung der Leistungshalbleitern 9 verringert.

## Patentansprüche

1. Flexibles Leistungselektronikmodul mit mindestens einem Schaltungsträger und mindestens einem Leistungshalbleiter, wobei der Schaltungsträger mit einem schichtartigen Aufbau vorgesehen ist, wobei die Basis von einem flexiblen Kunststoffträgersubstrat (1) gebildet ist, auf dem der Leistungshalbleiter (9) montiert ist, dass der Schaltungsträger (16) ein flexibles Entwärmungssubstrat (6) aufweist, das flächig auf dem Kunststoffträgersubstrat (1) angeordnet ist und dass der Schaltungsträger (16) ein flexibles Kontaktierungssubstrat (13) aufweist, das flächig auf dem sich aus Kunststoffträgersubstrat (1) und Entwärmungssubstrat (6) zusammensetzenden Bauteil (10) angeordnet ist **dadurch gekennzeichnet, dass** der Leistungshalbleiter (9) zwischen dem Kunststoffträgersubstrat (1) und dem Kontaktierungssubstrat (13) klemmend gehalten ist.

2. Leistungselektronikmodul nach Anspruch 1, **dadurch gekennzeichnet, dass** das Entwärmungssubstrat (6) mindestens eine Ausnehmung (8) zur Aufnahme des Leistungshalbleiters (9) aufweist.

3. Leistungselektronikmodul nach einem der vorhergehenden Ansprüche, **dadurch gekennzeichnet, dass** das Kunststoffträgersubstrat (1) mindestens eine mit dem Leistungshalbleiter (9) verbundene Hochstromverbindung (4) aufweist.

4. Leistungselektronikmodul nach einem der vorhergehenden Ansprüche, **dadurch gekennzeichnet, dass** das Kontaktierungssubstrat (13) mindestens eine Niederstrom- und/oder Hochstromverbindung (15) für den Leistungshalbleiter (9) aufweist.

5. Leistungselektronikmodul nach einem der vorhergehenden Ansprüche, **dadurch gekennzeichnet, dass** das Entwärmungssubstrat (6) eine Graphit-Folie (7) ist.

6. Leistungselektronikmodul nach einem der vorhergehenden Ansprüche, **dadurch gekennzeichnet, dass** zwischen Entwärmungssubstrat (6) und Leistungshableiter (9) ein Wärmeleitmittel (12) (Gap-Filler) angeordnet ist.

7. Leistungselektronikmodul nach einem der vorhergehenden Ansprüche, **dadurch gekennzeichnet, dass** das Kunststoffträgersubstrat (1) ein Polyimidsubstrat ist.

8. Leistungselektronikmodul nach einem der vorhergehenden Ansprüche, **dadurch gekennzeichnet, dass** das Kunststoffträgersubstrat (1) mindestens ein Entwärmungsflächenelement (5) aufweist, das mit dem Entwärmungssubstrat (6) in thermischen Kontakt steht.

9. Leistungselektronikmodul nach einem der vorhergehenden Ansprüche, **dadurch gekennzeichnet, dass** der Leistungshalbleiter (9) durch Verklebung und/oder Lötung auf dem Kunststoffträgersubstrat (1) montiert ist.

## Claims

1. Flexible power electronic module comprising at least one circuit carrier and at least one power semiconductor, wherein the circuit carrier is provided such that it has a layer-like construction, wherein the base is formed by a flexible plastics carrier substrate (1), on which the power semiconductor (9) is mounted, wherein the circuit carrier (16) has a flexible heat dissipation substrate (6) arranged in a planar fashion on the plastics carrier substrate (1), and wherein the circuit carrier (16) has a flexible contacting substrate (13) arranged in a planar fashion on the device (10) composed of plastics carrier substrate (1) and heat dissipation substrate (6), **characterized in that** the power semiconductor (9) is held in a clamping fashion between the plastics carrier substrate (1) and the contacting substrate (13).

2. Power electronic module according to Claim 1, **characterized in that** the heat dissipation substrate (6) has at least one cutout (8) for receiving the power semiconductor (9).

3. Power electronic module according to either of the preceding claims, **characterized in that** the plastics carrier substrate (1) has at least one high-current connection (4) connected to the power semiconductor (9).

4. Power electronic module according to any of the preceding claims, **characterized in that** the contacting substrate (13) has at least one low-current and/or high-current connection (15) for the power semiconductor (9).

5. Power electronic module according to any of the preceding claims, **characterized in that** the heat dissipation substrate (6) is a graphite film (7).

6. Power electronic module according to any of the preceding claims, **characterized in that** a heat-conducting medium (12) (gap filler) is arranged between heat dissipation substrate (6) and power semiconductor (9).

7. Power electronic module according to any of the preceding claims, **characterized in that** the plastics carrier substrate (1) is a polyimide substrate.

8. Power electronic module according to any of the preceding claims, **characterized in that** the plastics carrier substrate (1) has at least one heat dissipation surface element (5) which is in thermal contact with the heat dissipation substrate (6).

9. Power electronic module according to any of the preceding claims, **characterized in that** the power semiconductor (9) is mounted on the plastics carrier substrate (1) by adhesive bonding and/or soldering.

## Revendications

1. Module électronique de puissance flexible comportant au moins un support de circuit et au moins un semi-conducteur de puissance, dans lequel le support de circuit est doté d'une structure en couche, dans lequel la base est constituée d'un substrat de support en matière plastique flexible (1) sur lequel est monté le semi-conducteur de puissance (9), le support de circuit (16) comprend un substrat de dissipation thermique flexible (6) qui est disposé en surface sur le substrat de support en matière plastique (1) et le support de circuit (16) comprend un substrat de contact flexible (13) qui est disposé en surface sur le composant (10) constitué du substrat de support en matière plastique (1) et du substrat de dissipation thermique (6), **caractérisé en ce que** le semi-conducteur de puissance (9) est maintenu par liaison adhésive entre le substrat de support en matière plastique (1) et le substrat de contact (13).

2. Module électronique de puissance selon la revendication 1, **caractérisé en ce que** le substrat de dissipation thermique (6) comprend au moins un évidement (8) destiné à recevoir le semi-conducteur de puissance (9).

3. Module électronique de puissance selon l'une quelconque des revendications précédentes, **caractérisé en ce que** le substrat de support en matière plastique (1) comprend au moins une liaison à courant fort (4) connectée au semi-conducteur de puissance (9).

4. Module électronique de puissance selon l'une quelconque des revendications précédentes, **caractérisé en ce que** le substrat de contact (13) comprend au moins une liaison à courant faible et/ou à courant fort (15) destinée au semi-conducteur de puissance (9).

5. Module électronique de puissance selon l'une quelconque des revendications précédentes, **caractérisé en ce que** le substrat de dissipation thermique (6) est une feuille de graphite (7).

6. Module électronique de puissance selon l'une quelconque des revendications précédentes, **caractérisé en ce qu'**un moyen thermiquement conducteur (12) (charge de remplissage d'interstices) est disposé entre le substrat de dissipation thermique (6) et le semi-conducteur de puissance (9).

7. Module électronique de puissance selon l'une quelconque des revendications précédentes, **caractérisé en ce que** le substrat de support en matière plastique (1) est un substrat de polyimide.

8. Module électronique de puissance selon l'une quelconque des revendications précédentes, **caractérisé en ce que** le substrat de support en matière plastique (1) comprend au moins un élément plat de dissipation thermique (5) qui est en contact thermique avec le substrat de dissipation thermique (6).

9. Module électronique de puissance selon l'une quelconque des revendications précédentes, **caractérisé en ce que** le semi-conducteur de puissance (9) est monté par liaison adhésive et/ou brasage sur le substrat de support en matière plastique (1).
